# EUROPEAN PATENT APPLICATION

(11) **EP 4 759 614 A1**
(43) Date of publication of application: **17.06.2026**
(21) Application number: 25214659.2
(22) Date of filing: 10.11.2025
(51) Int. Cl.: B60L 15/00, H02M 7/483, H05K 7/14

(54) **SYSTEMS FOR EXTENSION BOARD FOR INVERTER FOR ELECTRIC VEHICLE**

(30) Priority: 10.12.2024 US 202418975548
(71) Applicant: Borgwarner Inc., Auburn Hills, Michigan 48326 (US)
(72) Inventor: MAYER, Andreas, Clarkston, MI (US); LOUCO, Lathom Alexander, Arden, NC (US); DEUSSEN, Joel, Royal Oaks, MI (US); APELSMEIER, Andreas, Pollenfeld (DE); AKKALA, Naga Venkata Kishore, Nuremberg (DE); UGARE, Chetan, Nuremberg (DE); BERINDAN, Stefan, Oberasbach (DE)
(74) Representative: Office Freylinger

(57) **Abstract**

A system includes a multi-level inverter configured to convert DC power to AC power to drive a motor, wherein the multi-level inverter includes: a first printed circuit board for a two-level inverter; a power module electrically connected to the first printed circuit board; and a second printed circuit board electrically connected to the power module and to the first printed circuit board, wherein the second printed circuit board includes: one or more switches; one or more capacitors electrically connected to the one or more switches; and one or more controllers to control the one or more switches.

## Description

### TECHNICAL FIELD

Various embodiments of the present disclosure relate generally to systems for an extension board for an inverter, and, more particularly, to systems for an extension board for a multi-level inverter for an electric vehicle.

### BACKGROUND

Inverters, such as those used to drive a motor in an electric vehicle, for example, are responsible for converting High Voltage Direct Current (HVDC) into Alternating Current (AC) to drive the motor. In some systems, two-level inverters have a simple structure and a relatively low cost of production. However, some two-level inverters may generate an output voltage including a high level of harmonics and a relatively low efficiency at a higher switching frequency. The present disclosure is directed to overcoming one or more of these above-referenced challenges.

### SUMMARY OF THE DISCLOSURE

In some aspects, the techniques described herein relate to a system including a multi-level inverter configured to convert DC power to AC power to drive a motor, wherein the multi-level inverter includes: a first printed circuit board for a two-level inverter; a power module electrically connected to the first printed circuit board; and a second printed circuit board electrically connected to the power module and to the first printed circuit board, wherein the second printed circuit board includes: one or more switches; one or more capacitors electrically connected to the one or more switches; and one or more controllers to control the one or more switches.

In some aspects, the techniques described herein relate to a system, further including: one or more heat exchangers on the second printed circuit board.

In some aspects, the techniques described herein relate to a system, further including: a first heatsink on the power module; and a second heatsink on the power module.

In some aspects, the techniques described herein relate to a system, wherein the second printed circuit board is on a first side of the first printed circuit board, the power module is on a second side, and wherein one or more leads extend through the first printed circuit board.

In some aspects, the techniques described herein relate to a system, wherein the second printed circuit board is provided on a second side of the first printed circuit board.

In some aspects, the techniques described herein relate to a system, wherein the second printed circuit board is provided between the first printed circuit board and the power module.

In some aspects, the techniques described herein relate to a system, wherein the power module is provided between the first printed circuit board and the second printed circuit board.

In some aspects, the techniques described herein relate to a system, wherein the one or more switches and capacitor of the second printed circuit board are on opposite sides of the second printed circuit board.

In some aspects, the techniques described herein relate to a system, wherein the one or more switches and capacitor of the second printed circuit board are on a same side of the second printed circuit board.

In some aspects, the techniques described herein relate to a system, further including: a bulk capacitor electrically connected to the power module.

In some aspects, the techniques described herein relate to a system, further including: a battery configured to supply the DC power to the multi-level inverter; and the motor configured to receive the AC power from the multi-level inverter to drive the motor, wherein the multi-level inverter, the battery, and the motor are provided as a vehicle.

In some aspects, the techniques described herein relate to a three-level extension board including: one or more three-level switches to be connected to one or more two-level switches of a two-level board of an inverter.

In some aspects, the techniques described herein relate to a three-level extension board, further including: one or more capacitors electrically connected to the one or more three-level switches.

In some aspects, the techniques described herein relate to a three-level extension board, further including: one or more controllers to control the one or more three-level switches.

In some aspects, the techniques described herein relate to a three-level extension board, further including: one or more board-to-board connectors to electrically connect the three-level extension board to the two-level board.

In some aspects, the techniques described herein relate to a multi-level extension board for a lower-level board of an inverter, the multi-level extension board including: one or more multi-level switches to be connected to one or more switches of the lower-level board; one or more capacitors electrically connected to the one or more multi-level switches; and one or more controllers to control the one or more multi-level switches.

In some aspects, the techniques described herein relate to a multi-level extension board, wherein the one or more multi-level switches are three-level switches.

In some aspects, the techniques described herein relate to a multi-level extension board, wherein the lower-level board is a two-level inverter board, and the multi-level extension board is a three-level inverter board.

In some aspects, the techniques described herein relate to a multi-level extension board, wherein the one or more controllers include one or more gate drivers for the one or more multi-level switches.

In some aspects, the techniques described herein relate to a multi-level extension board, wherein the one or more controllers include one or more of a gate driver power supply, a protection circuit, or a neutral point voltage sensor.

Additional objects and advantages of the disclosed embodiments will be set forth in part in the description that follows, and in part will be apparent from the description, or may be learned by practice of the disclosed embodiments. The objects and advantages of the disclosed embodiments will be realized and attained by means of the elements and combinations particularly pointed out in the appended claims.

It is to be understood that both the foregoing general description and the following detailed description are exemplary and explanatory only and are not restrictive of the disclosed embodiments, as claimed.

### BRIEF DESCRIPTION OF THE DRAWINGS

The accompanying drawings, which are incorporated in and constitute a part of this specification, illustrate various exemplary embodiments and together with the description, serve to explain the principles of the disclosed embodiments.
FIG. 1 depicts an exemplary system infrastructure for a vehicle including a combined inverter and converter, according to one or more embodiments.
FIG. 2 depicts an exemplary system infrastructure for the combined inverter and converter of FIG. 1, according to one or more embodiments.
FIG. 3 depicts an exemplary electrical schematic of a T-Type three-level inverter, according to one or more embodiments.
FIG. 4 depicts a three-level extension printed circuit board, according to one or more embodiments.
FIG. 5 depicts a single side cooling system including an extension PCB located above a main PCB, according to one or more embodiments.
FIG. 6 depicts a single side cooling system including an extension PCB located below a main PCB, according to one or more embodiments.
FIG. 7 depicts a double side cooling system with an extension PCB including components on one side, according to one or more embodiments.
FIG. 8 depicts a double side cooling system with an extension PCB including components on two sides, according to one or more embodiments.

### DETAILED DESCRIPTION OF EMBODIMENTS

Both the foregoing general description and the following detailed description are exemplary and explanatory only and are not restrictive of the features, as claimed. As used herein, the terms "comprises," "comprising," "has," "having," "includes," "including," or other variations thereof, are intended to cover a non-exclusive inclusion such that a process, method, article, or apparatus that comprises a list of elements does not include only those elements, but may include other elements not expressly listed or inherent to such a process, method, article, or apparatus. In this disclosure, unless stated otherwise, relative terms, such as, for example, "about," "substantially," and "approximately" are used to indicate a possible variation of ±10% in the stated value. In this disclosure, unless stated otherwise, any numeric value may include a possible variation of ±10% in the stated value.

The terminology used below may be interpreted in its broadest reasonable manner, even though it is being used in conjunction with a detailed description of certain specific examples of the present disclosure. Indeed, certain terms may even be emphasized below; however, any terminology intended to be interpreted in any restricted manner will be overtly and specifically defined as such in this Detailed Description section. For example, in the context of the disclosure, the switching devices may be described as switches or devices, but may refer to any device for controlling the flow of power in an electrical circuit. For example, switches may be metal-oxide-semiconductor field-effect transistors (MOSFETs), bipolar junction transistors (BJTs), insulated-gate bipolar transistors (IGBTs), or relays, for example, or any combination thereof, but are not limited thereto.

Various embodiments of the present disclosure relate generally to systems for an extension board for an inverter, and, more particularly, to systems for an extension board for a multi-level inverter for an electric vehicle. Inverters, such as those used to drive a motor in an electric vehicle, for example, are responsible for converting Direct Current (DC) into Alternating Current (AC) to drive the motor. A three phase inverter may include a bridge with six power device switches (for example, power transistors such as IGBT or MOSFET) that are controlled by Pulse Width Modulation (PWM) signals generated by a controller.

Two-level (2L) inverters dominate the traction inverter market due to cost and simple structure. However, a three-level (3L) inverter topology addresses issues with the 2L inverters, such as the harmonics in output voltage and relatively low efficiency at a higher switching frequency. In contrast to 2L inverters, multi-level (e.g., 3L) inverters can generate output voltage waveforms with lower harmonics to better resemble the sinusoidal references. Moreover, lower dv/dt and electromagnetic interference (EMI) emissions can be achieved using multi-level topology. A T-type topology 3L inverter may be a most suitable topology among the multi-level inverters due to three-level output voltage capability and lesser number of switching devices.

One or more embodiments may provide an additional PCB board to expand a 2L inverter to a 3L inverter, or a lower-level inverter to a higher-level inverter. By introducing the extension board into the system, one or more embodiments may provide an inverter with the capability of functioning in a 3L operation mode. One or more embodiments may provide an additional PCB with embedded switches, gate drivers, supplies, and capacitors. One or more embodiments may provide an additional PCB that is connectable to a 2L inverter using dedicated power leads and one or more board-to-board (B2B) connectors to the control PCB of the 2L inverter.

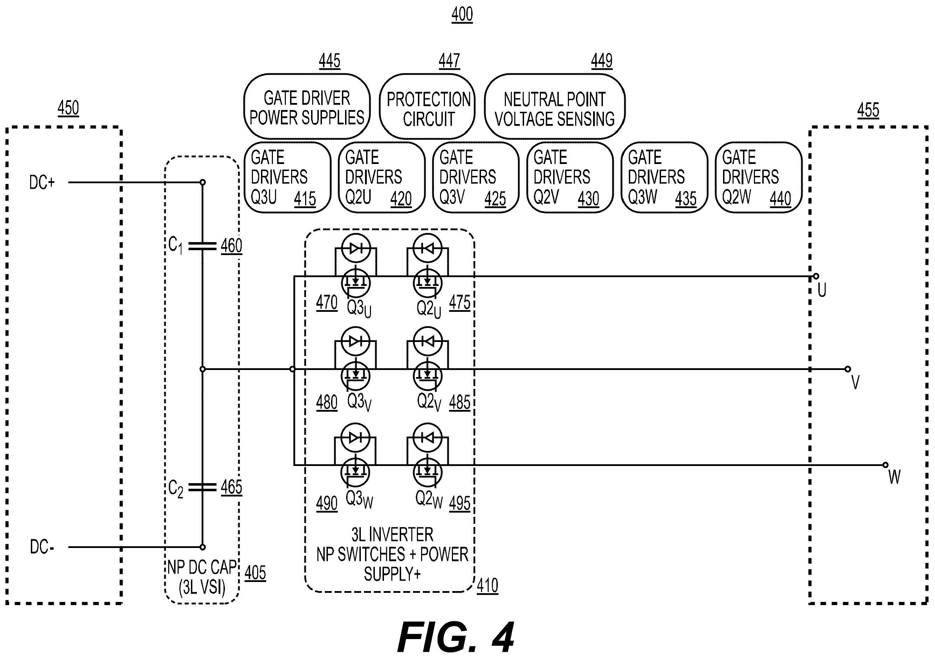

One or more embodiments may include an additional board including 3L electronics. 3L electronics may be represented by: neutral point (NP) DC CAP (3L VSI) (DC capacitor 3L voltage source inverter) (e.g., DC capacitor 405), the 3L inverter NP switches together with the gate driver (e.g., three-level inverter NP switches 410), and gate drivers power supplies (e.g., gate driver power supplies 445) and neutral point voltage sensor (e.g., neutral point voltage sensor 449) as shown in FIG. 4. One or more embodiments may provide an additional PCB board with current sensing, which may reduce the requirement of having an extra dedicated board for power sensing.

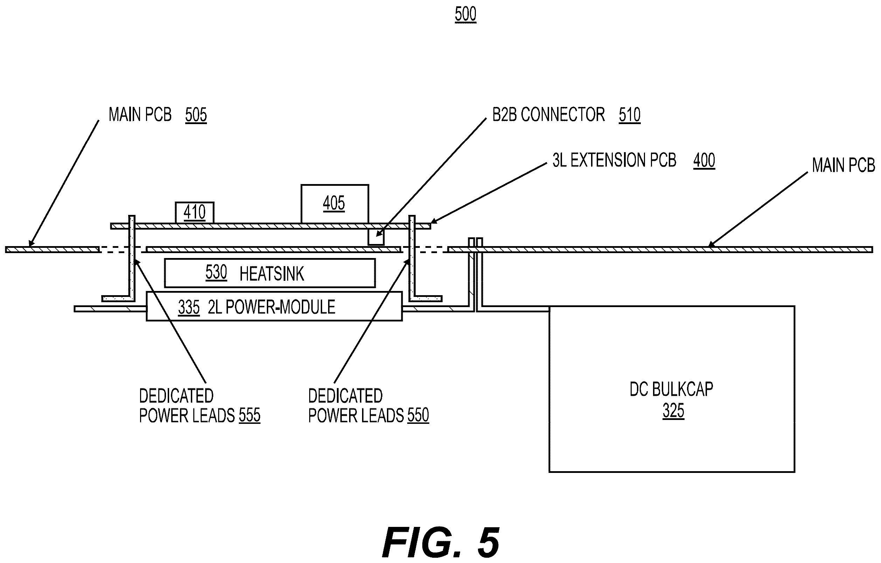

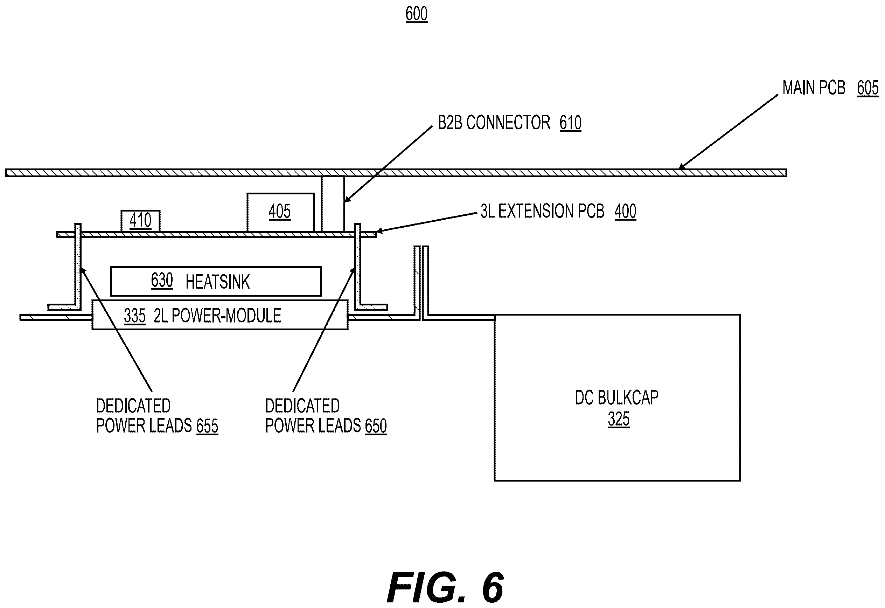

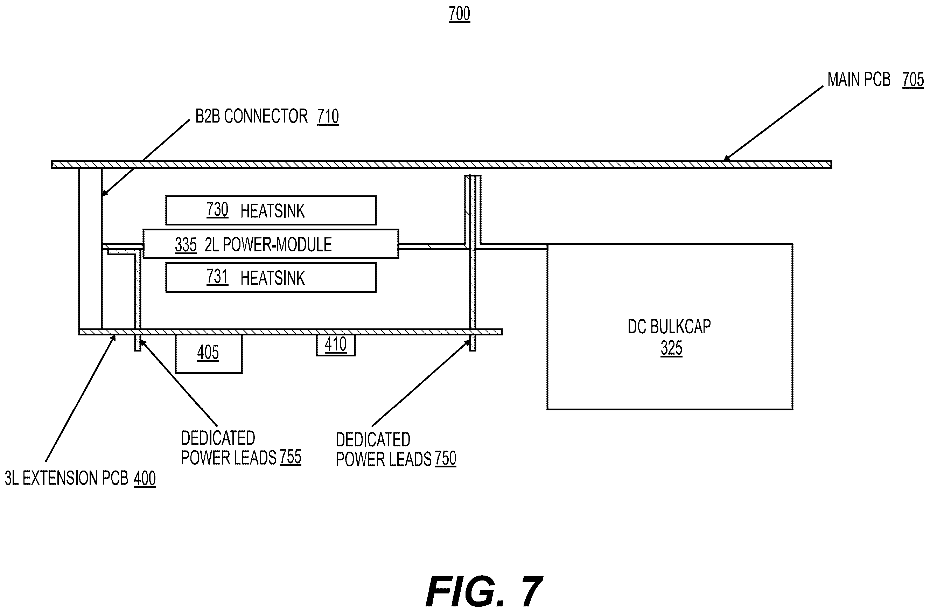

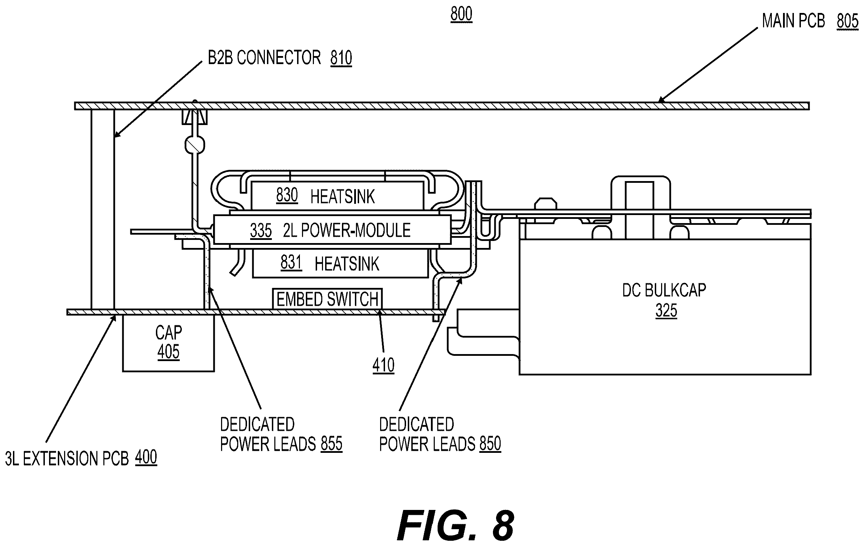

One or more embodiments may provide an extension board that adds a 3L functionality to an existing 2L inverter with an integrated plug and play preparation for the integration. The extension board may be added at the end or during the inverter assembly process. The plug and play preparation may be represented by the space availability in the housing and the dedicated electronics required for integration on the main PCB. This type of extension board may be integrated in a single side cooling system (see e.g., FIG. 5 and FIG. 6) or may be integrated in a dual side cooling system (see e.g., FIG. 7 and FIG. 8). Plug and play preparation may refer to the first board from a 2L inverter including an interface to allow an extension board connection. Plug and play preparation may refer to a main PCB or board including an interface with a board-to-board connector with control signals, supply, and monitoring sensing signals.

One or more embodiments may include a 3L inverter. One or more embodiments may provide an extension from a 2L to 3L inverter while re-using all 2L components and the basic 2L power cell design. One or more embodiments may be used as extension option of the 2L inverter. One or more embodiments may realize 2L operation with a very low power cell loop in combination with a low inductive and symmetric power cell for the T leg loops. The extension board may be flexible and scalable for different power, voltage levels, and capacitance values. The manufacturing process from the 2L inverter may be re-used. One or more embodiments may include an addition or adaptation of an extension power board that adds a 3 Level T-type VSI (voltage source inverter) topology and functionality to an existing 2L VSI. One or more embodiments may include cooling of components of the extension board over a thermal path to the main heatsinks of the 2L VSI. One or more embodiments may include a multi-level inverter configured to convert DC power to AC power to drive a motor. The multi-level inverter may include a second printed circuit board (PCB) with one or more heat exchangers. The heat exchangers may include heat sinks or other components for cooling. Direct electrical connection of the PCB to the power leads of the 2L VSI with additional leads may be provided. All additional components to extend a 2L Inverter to a 3L T-Type inverter may be arranged on one additional PCB. Each phase leg may be realized with a separate PCB. 2L VSI with preparation for an extension board for a 3L inverter may be provided, which in one or more embodiments may include a control board with signal and supply interface for 3L operation, power lead design for additional connection of the extension board, and heatsink prepared for cooling of additional components.

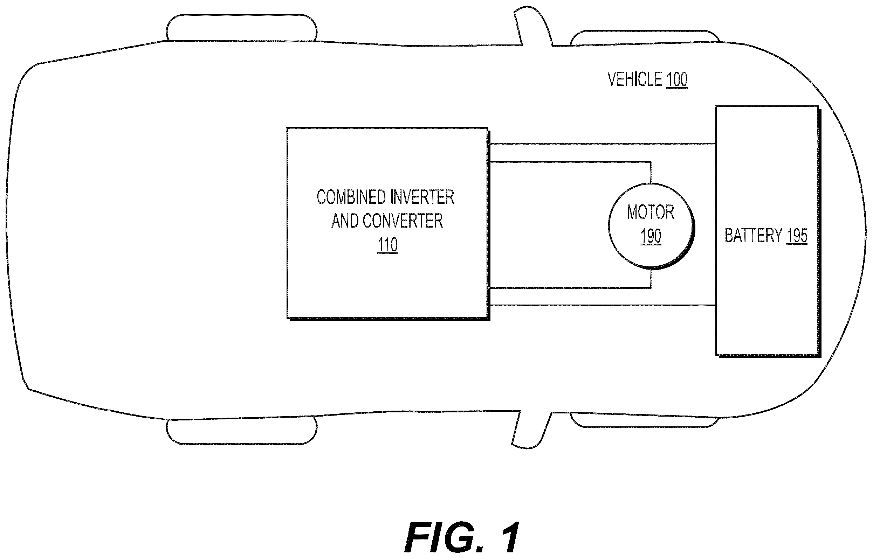

FIG. 1 depicts an exemplary system infrastructure for a vehicle including a combined inverter and converter, according to one or more embodiments. Alternatively, the inverter may be an inverter without a converter. In the context of this disclosure, the inverter without a converter, or the combined inverter and converter, may be referred to as an inverter. As shown in FIG. 1, electric vehicle 100 may include an inverter 110, a motor 190, and a battery 195. The inverter 110 may include components to receive electrical power from an external source and output electrical power to charge the battery 195 of electric vehicle 100. The inverter 110 may convert DC power from the battery 195 in electric vehicle 100 to AC power, to drive (e.g. rotate) the motor 190 of the electric vehicle 100, for example, but the embodiments are not limited thereto. The inverter 110 may be bidirectional, and may convert DC power to AC power, or convert AC power to DC power, such as during regenerative braking, for example. The inverter 110 may be a three-phase inverter, a single-phase inverter, or a multi-phase inverter.

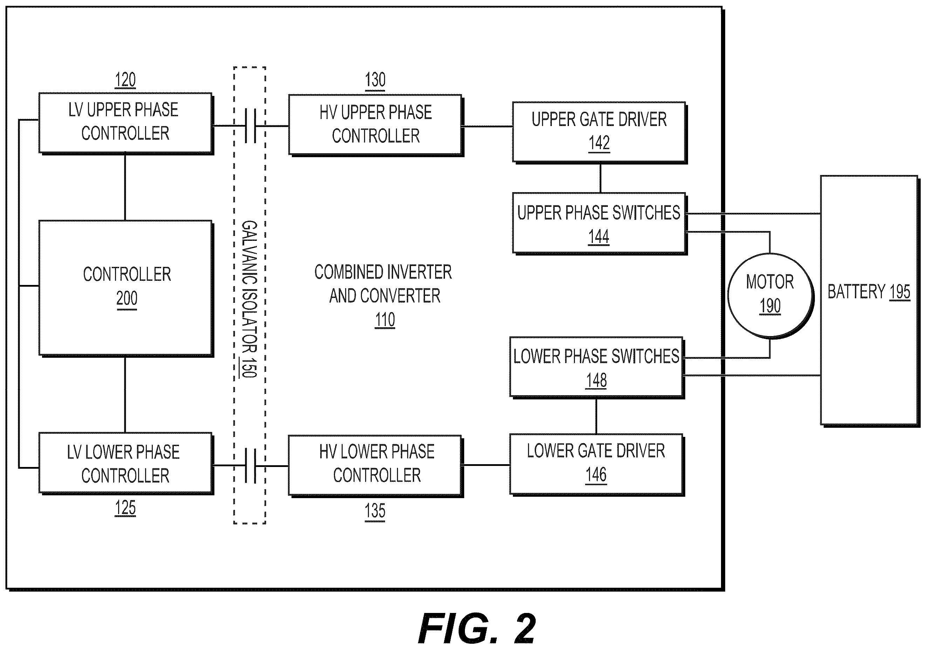

FIG. 2 depicts an exemplary system infrastructure for the combined inverter and converter of FIG. 1, according to one or more embodiments. Inverter 110 may include an inverter controller 200 to control the inverter 110. Inverter 110 may include a low voltage upper phase controller 120 separated from a high voltage upper phase controller 130 by a galvanic isolator 150. Inverter 110 may include a low voltage lower phase controller 125 separated from a high voltage lower phase controller 135 by galvanic isolator 150. Inverter 110 may include a high voltage upper phase controller 130 including a gate driver power supply, an upper gate driver 142, and upper phase switches 144. Inverter 110 may include a high voltage lower phase controller 135 including a gate drive power supply, a lower gate driver 146, and lower phase switches 148. Upper phase switches 144 and lower phase switches 148 may be connected to motor 190 and battery 195. Galvanic isolator 150 may be one or more of optical, transformer-based, or capacitance-based isolation, but embodiments are not limited thereto. Galvanic isolator 150 may be one or more capacitors with a value from approximately 20fF to approximately 100fF, with a breakdown voltage from approximately 6kV to approximately 12kV, for example, but embodiments are not limited thereto. Galvanic isolator 150 may include a pair of capacitors, where one capacitor of the pair carries an inverse data signal from the other capacitor of the pair to create a differential signal for common-mode noise rejection. Galvanic isolator 150 may include more than one capacitor in series. Galvanic isolator 150 may include one capacitor located on a first IC, or may include a first capacitor located on a first IC and a second capacitor located on a second IC that communicates with the first IC.

Inverter 110 may include a low voltage area, where voltages are generally less than 5V, for example, and a high voltage area, where voltages may exceed 500V, for example. The low voltage area may be separated from the high voltage area by galvanic isolator 150. Inverter controller 200 may be in the low voltage area of inverter 110, and may send signals to and receive signals from low voltage upper phase controller 120. Low voltage upper phase controller 120 may be in the low voltage area of inverter 110, and may send signals to and receive signals from high voltage upper phase controller 130. Low voltage upper phase controller 120 may send signals to and receive signals from low voltage lower phase controller 125. High voltage upper phase controller 130 may be in the high voltage area of inverter 110. Accordingly, signals between low voltage upper phase controller 120 and high voltage upper phase controller 130 pass through galvanic isolator 150. High voltage upper phase controller 130 may send signals to and receive signals from the upper gate driver 142. The upper gate driver 142 may send signals to and receive signals from the upper phase switches 144. Upper phase switches 144 may be connected to motor 190 and battery 195. Upper phase switches 144 and lower phase switches 148 may be used to transfer energy from motor 190 to battery 195, from battery 195 to motor 190, from an external source to battery 195, or from battery 195 to an external source, for example. The lower phase system of inverter 110 may be similar to the upper phase system as described above.

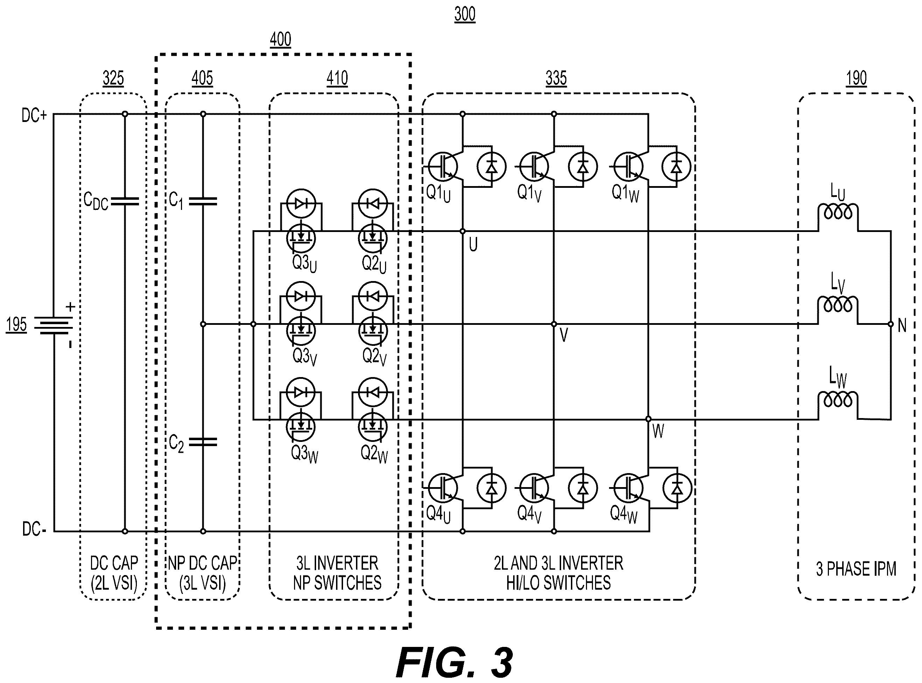

FIG. 3 depicts an exemplary electrical schematic of a T-Type three-level inverter, according to one or more embodiments. Inverter system 300, which may be a T-Type three-level inverter, may include motor 190, battery 195, DC bulk capacitor 325, three-level extension board 400, and two-level power module 335. Battery 195 may be connected to DC bulk capacitor 325. Three-level extension board 400 may include DC capacitor 405 and three-level inverter NP switches 410. Three-level extension board 400 may be electrically connected to two-level power module 335. Two-level power module 335 may be connected to motor 190. Two-level power module 335 may include components of inverter 110, such as galvanic isolator 150, high voltage upper phase controller 130, high voltage lower phase controller 135, upper gate driver 142, upper phase switches 144, lower gate driver 146, and lower phase switches 148, for example. However, the disclosure is not limited thereto.

FIG. 4 depicts a three-level extension printed circuit board, according to one or more embodiments. Three-level extension board 400 may include DC capacitor 405, three-level inverter NP switches 410, Q3u gate drivers 415, Q2u gate drivers 420, Q3v gate drivers 425, Q2v gate drivers 430, Q3w gate drivers 435, Q2w gate drivers 440, gate driver power supplies 445, DC power leads 450, and AC power leads 455. DC power leads 450 may be connected to DC capacitor 405. DC capacitor 405 may include DC capacitor 460 and DC capacitor 465. Three-level inverter NP switches 410 may connect to DC capacitor 405. Three-level inverter NP switches 410 may include Q3u switch 470, Q2u switch 475, Q3v switch 480, Q2v switch 485, Q3w switch 490, and Q2w switch 495. Three-level inverter NP switches 410 may connect to AC power leads 455. Three-level extension board 400 may include Q3u gate drivers 415, Q2u gate drivers 420, Q3v gate drivers 425, Q2v gate drivers 430, Q3w gate drivers 435, and Q2w gate drivers 440. Three-level extension board 400 may include gate driver power supplies 445, protection circuit 447, and neutral point voltage sensor 449. Three-level extension board 400 may be a second PCB electronically connected to a main PCB, which may be a first PCB.

FIG. 5 depicts a single side cooling system including an extension PCB located above a main PCB, according to one or more embodiments. Inverter 500 may include main PCB 505 first PCB, board-to-board connector 510, three-level extension board 400, second PCB, heatsink 530, two-level power module 335 power module, DC power leads 550, AC power leads 555, DC capacitor 405, and three-level inverter NP switches 410. Main PCB 505 may be a first PCB.

Inverter 500 may include three-level extension board 400 to expand a 2 Level inverter to a 3 Level inverter. By introducing the three-level extension board 400 into the system, the inverter may function in a 3 Level operation mode. As an example, three-level extension board 400 may include embedded switches such as three-level inverter NP switches 410, gate drivers, supplies, and capacitors that may be connected to a 2 Level inverter using the dedicated power leads (e.g., AC power leads 555 or DC power leads 550), and a board-to-board connector 510 to the control PCB of the 2 Level inverter, which may be main PCB 505.

FIG. 6 depicts a single side cooling system including an extension PCB located below a main PCB, according to one or more embodiments. Inverter 600 may include main PCB 605, board-to-board connector 610, three-level extension board 400, DC bulk capacitor 325, heatsink 630, two-level power module 335, DC power leads 650, AC power leads 655, DC capacitor 405, and three-level inverter NP switches 410.

FIG. 7 depicts a double side cooling system with an extension PCB including components on one side, according to one or more embodiments. Inverter 700 may include main PCB 705, board-to-board connector 710, three-level extension board 400, DC bulk capacitor 325, heatsink 730, heatsink 731, two-level power module 335, DC power leads 750, AC power leads 755, DC capacitor 405, and three-level inverter NP switches 410. Inverter 700 may depict two-level power module 335 between main PCB 705 and three-level extension board 400. Main PCB 705 and three-level extension board 400 may be connected by board-to-board connector 710. Heatsink 730 and heatsink 731 may be located on one or more sides of two-level power module 335. DC capacitor 405 and three-level inverter NP switches 410 may be on one side (i.e., the same side) of three-level extension board 400.

FIG. 8 depicts a double side cooling system with an extension PCB including components on two sides, according to one or more embodiments. Inverter 800 may include main PCB 805, board-to-board connector 810, three-level extension board 400, DC bulk capacitor 325, heatsink 830, heatsink 831, two-level power module 335, DC power leads 850, AC power leads 855, DC capacitor 405, and three-level inverter NP switches 410. DC capacitor 405 and three-level inverter NP switches 410 may be on two sides (i.e., opposite sides) of three-level extension board 400.

One or more embodiments may provide an additional PCB board to expand a 2L inverter to a 3L inverter. By introducing the extension board into the system, one or more embodiments may provide an inverter with the capability of functioning in a 3L operation mode. One or more embodiments may provide an additional PCB with embedded switches, gate drivers, supplies, and capacitors. One or more embodiments may provide an additional PCB that is connectable to a 2L inverter using dedicated power leads and one or more board-to-board (B2B) connectors to the control PCB of the 2L inverter. One or more embodiments may provide an additional PCB board with current sensing, which may reduce the requirement of having an extra dedicated board for power sensing.

One or more embodiments may provide an extension board that adds a 3L functionality to an existing 2L inverter with an integrated plug and play preparation for the integration. One or more embodiments may provide an extension from a 2L to 3L inverter while re-using all 2L components and the basic 2L power cell design. One or more embodiments may be used as extension option of the 2L inverter. One or more embodiments may realize 2L operation with a very low power cell loop in combination with a low inductive and symmetric power cell for the T leg loops. The extension board may be flexible and scalable for different power, voltage levels, and capacitance values. The manufacturing process from the 2L inverter may be re-used.

One or more embodiments may include an addition or adaptation of an extension power board that adds a 3 Level T-type VSI (voltage source inverter) topology and functionality to an existing 2L VSI. Direct electrical connection of the PCB to the power leads of the 2L VSI with additional leads may be provided. All additional components to extend a 2L Inverter to a 3L T-Type inverter may be arranged on one additional PCB.

Other embodiments of the disclosure will be apparent to those skilled in the art from consideration of the specification and practice of the invention disclosed herein. It is intended that the specification and examples be considered as exemplary only, with a true scope of the invention being indicated by the following claims.

## Claims

1. A system comprising a multi-level inverter configured to convert DC power to AC power to drive a motor, wherein the multi-level inverter includes:
a first printed circuit board for a two-level inverter;
a power module electrically connected to the first printed circuit board; and
a second printed circuit board electrically connected to the power module and to the first printed circuit board, wherein the second printed circuit board includes:
one or more switches;
one or more capacitors electrically connected to the one or more switches; and
one or more controllers to control the one or more switches.

2. The system of claim 1, further comprising:
one or more heat exchangers on the second printed circuit board.

3. The system of any one of claims 1 to 2, further comprising:
a first heatsink on the power module; and
a second heatsink on the power module.

4. The system of any one of claims 1 to 3,
wherein the second printed circuit board is on a first side of the first printed circuit board, the power module is on a second side, and wherein one or more leads extend through the first printed circuit board;
and/or wherein the second printed circuit board is provided on a second side of the first printed circuit board.
and/or wherein the second printed circuit board is provided between the first printed circuit board and the power module.
and/or wherein the power module is provided between the first printed circuit board and the second printed circuit board.

5. The system of any one of claims 1 to 4, wherein the one or more switches and capacitor of the second printed circuit board are on opposite sides of the second printed circuit board;
and/or wherein the one or more switches and capacitor of the second printed circuit board are on a same side of the second printed circuit board.

6. The system of any one of claims 1 to 5, further comprising:
a bulk capacitor electrically connected to the power module.

7. The system of any one of claims 1 to 6, further comprising:
a battery configured to supply the DC power to the multi-level inverter; and
the motor configured to receive the AC power from the multi-level inverter to drive the motor,
wherein the multi-level inverter, the battery, and the motor are provided as a vehicle.

8. A three-level extension board comprising:
one or more three-level switches to be connected to one or more two-level switches of a two-level board of an inverter.

9. The three-level extension board of claim 8, further comprising:
one or more capacitors electrically connected to the one or more three-level switches.

10. The three-level extension board of any one of claims 8 to 9, further comprising:
one or more controllers to control the one or more three-level switches.

11. The three-level extension board of any one of claims 8 to 10, further comprising:
one or more board-to-board connectors to electrically connect the three-level extension board to the two-level board.

12. A multi-level extension board for a lower-level board of an inverter, the multi-level extension board comprising:
one or more multi-level switches to be connected to one or more switches of the lower-level board;
one or more capacitors electrically connected to the one or more multi-level switches; and
one or more controllers to control the one or more multi-level switches.

13. The multi-level extension board of claim 16, wherein the one or more multi-level switches are three-level switches.

14. The multi-level extension board of claim 12, wherein the lower-level board is a two-level inverter board, and the multi-level extension board is a three-level inverter board.

15. The multi-level extension board of claim 12 or 13, wherein the one or more controllers include one or more gate drivers for the one or more multi-level switches;
and, preferably, wherein the one or more controllers include one or more of a gate driver power supply, a protection circuit, or a neutral point voltage sensor.
